# EUROPEAN PATENT SPECIFICATION

(11) **EP 4 386 823 B1**
(45) Date of publication and mention of the grant of the patent: **12.02.2025**
(21) Application number: 22212687.2
(22) Date of filing: 12.12.2022
(51) Int. Cl.: H01L 21/677, H01S 5/028

(54) **METHOD OF PASSIVATING CLEAVED SEMICONDUCTOR STRUCTURE**
VERFAHREN ZUR PASSIVIERUNG GESPALTENER HALBLEITERSTRUKTUREN
PROCÉDÉ DE PASSIVATION DE STRUCTURE SEMI-CONDUCTRICE CLIVÉE

(43) Date of publication of application: 19.06.2024
(73) Proprietor: Comptek Solutions OY, 20520 Turku (FI)
(72) Inventor: MÄKELÄ, Jaakko, Turku (FI); LÅNG, Jouko, Lieto (FI); CALVO ALONSO, Vicente, Piispanristi (FI)
(74) Representative: Novagraaf Group

(56) References cited:
- EP-A1- 3 399 606
- US-A1- 2002 042 157
- US-A1- 2004 113 160
- US-A1- 2008 181 275
- US-A1- 2018 230 624
- US-A1- 2019 093 213

## Description

### TECHNICAL FIELD

The present disclosure relates to passivation of semiconductor devices. More specifically the present disclosure relates to a method of passivating a cleaved semiconductor structure for utilization as an edge-emitting laser device.

### BACKGROUND

Semiconductor lasers, or diode lasers, are electro-optical devices operable to convert electrical energy into light, for implementation in a plethora of applications. Particularly, semiconductor lasers based upon III-V semiconductor compounds are widely used for high-speed optical recording, high-speed printing, various networks, and transmissions, doppler optical radar, optical signal processing, high-speed optical microwave sources, pump sources for other solid-state lasers, fibre amplifiers, medical applications, and so forth.

Such diode lasers, having multiple controllable properties and diverse applications, create a continuous need for appropriate improvements to one or more desired properties of the emitted light and/or the reliability of the device. For instance, in high-power applications, the maximum amount of output power is desired for operation. However, the output power is often limited by the gradual damage to the device itself. Herein, a dominant root cause of failure for high power semiconductor lasers is known as Catastrophic Optical Mirror Damage (COMD), a phenomenon which impairs the maximum output of a high-power edge-emitting laser chip. The root-cause of the failure by COMD are the surface defects at output facet(s) of the laser chip. The light emitted by the semiconductor laser is partially absorbed by the surface, wherein the defects act as non-radiative recombination centres, resulting in an increased heat generation due to the recombination of charge carriers excited by the partially absorbed light. Typically, while the temperature increases, the effective band gap of the material decreases, which leads to more absorption and non-radiative recombination. On the other hand, the increase of temperature also results in the redistribution of molecular bonds that generally results in a higher defect density in absence of strong, well-ordered molecular bonds at the interface. Moreover, the extended operation at high output power generates significant amounts of heat that causes degradation of one or more mirrors arranged at one or more facets of the semiconductor laser.

As a result of the degradation, the corresponding mirror damage shortens the lifetime of the semiconductor laser and thereby increases operational costs due to the need for frequent laser replacements. Moreover, such effects prohibit the positive feedback-loop and lead to a quick micro-explosion of the facet once the optical power threshold level of COMD has been exceeded. In an exemplary scenario, aluminium (Al) - containing compound semiconductor lasers have been observed to be most sensitive to COMD owing to their extremely high tendency to interact with oxygen, which in turn is responsible for the defect states in many cases. Apart from the Al and oxygen (O) bonds having a natural tendency to form defect states, there also exists a marked difficulty to reduce such defects due to their thermodynamical stability. Consequently, majority of the known methods to avoid Al-O bonds at the surface relate to preventing exposure of the facet to oxygen before coating.

There have been some attempts to solve the aforementioned problems. In some examples, Argon (Ar) ion beam etching (either positive or negative), remote plasma etching, or atomic hydrogen oxide reduction is used for removing surface oxide layers, with subsequent Silicon, Silicon nitrides (SiNₓ), Silicon hydride (SiH), or crystalline ZnSe-deposition to passivate the surface with a lowered defect-state density and protect the facet from further oxidation. In other examples, ultra-high vacuum (UHV) systems are configured to utilize a cleaning method in general, and a subsequent deposition of at least 10 nm thickness crystalline passivation layer, e.g., ZnSe. Further herein, steps like loading, cleaning, deposition, and flipping of the sample are done in different chambers of the system. Although, the system does not have any breaks of vacuum (or exposure to surroundings) between any of the steps; however, it is still highly complex and slower in comparison to processes and/or systems that could be executed in a single chamber. Further, in some examples, ZnSe crystalline layer is used as a protective/passivation coating. Herein, atomic hydrogen etching as a cleaning method is utilized for avoiding defect-generation from the etching itself. For non-Al compound semiconductors, such method may provide a high-quality interface; however, the atomic hydrogen may not provide efficient removal of Al-O bonds by itself. Further, in some examples, low-energy hydrogen plasma is utilized for cleaning followed by overcoating with a hydrogenated amorphous silicon (α-Si:H), utilizing low-energy Ar+-ion beam or plasma to remove the surface native oxide, and subsequent Si-coating.

All above-described passivation methods require removal of the native oxide before, or simultaneously with, the passivation treatment. Another technique involves avoiding altogether the Al-O bonds from existing on the laser facet, known as E2 technique. The E2 technique involves avoiding oxide formation on the surface by preventing facet of a device from any exposure to its surroundings until it is cleaved from the processed wafer. This cleaving takes place in UHV "in-situ", after which the device is coated with a thin layer of any one of Silicon (Si), Germanium (Ge), or Antimony (Sb), wherein the surface coating needs to have an absorption edge to facilitate the propagation of light out of the device and at the same time protect the active area interface from interacting with oxygen from the surrounding. However, one of the major drawbacks of the E2 method is the requirement of cleaving the processed wafer into bars within UHV, which is a highly complex process to implement and execute, with very low throughput and requiring highly expensive equipment. It may be appreciated that if the laser bars are cleaved "ex-situ", i.e., outside of UHV, the oxidation of laser facet is unavoidable, bringing the defect states from the native oxide present on the laser facet. Prior art passivation and deposition methods are known from EP3399606A1 and US2018230624 A1.

### SUMMARY

The present disclosure seeks to provide a method and a system of passivating a cleaved semiconductor structure for utilization as an edge-emitting laser device. The present disclosure further seeks to provide an edge-emitting laser device formed by the method. An aim of the present disclosure is to provide a solution that overcomes at least partially the problems encountered in prior art.

In one aspect, an embodiment of the present disclosure provides a method of passivating a cleaved semiconductor structure for utilization as an edge-emitting laser device, the method comprising:
- providing an enclosure having a first chamber and a second chamber, a transfer arm to receive and transfer a given structure from the first chamber to the second chamber, and a fixture to mount the given structure thereon in the second chamber, and with each of the first chamber and the second chamber adapted to provide vacuum condition inside thereof;
- loading the cleaved semiconductor structure defining a first facet, in the first chamber, onto the transfer arm therein;
- transferring the cleaved semiconductor structure from the first chamber to the second chamber using the transfer arm, to have the cleaved semiconductor structure mounted onto the fixture in the second chamber;
- exposing the first facet of the cleaved semiconductor structure in the second chamber to a cleaning beam from a cleaning source opposing the first facet by manipulating the fixture therein, to remove a possible native oxide layer formed on the first facet of the cleaved semiconductor structure;
- exposing the first facet of the cleaved semiconductor structure in the second chamber to heat energy from a heating source opposing the first facet by manipulating the fixture therein, to heat the first facet of the cleaved semiconductor structure; and
- exposing the first facet of the cleaved semiconductor structure in the second chamber to an oxidation agent from an oxidizing source opposing the first facet by manipulating the fixture therein, to form an ordered oxide layer on the first facet of the cleaved semiconductor structure.

In another aspect, an embodiment of the present disclosure provides a system for passivating a cleaved semiconductor structure for utilization as an edge-emitting laser device, the system comprising:
- an enclosure having a first chamber and a second chamber;
- a pump configured to generate vacuum condition inside each of the first chamber and the second chamber;
- a cleaning source mounted in the second chamber;
- a heating source mounted in the second chamber;
- an oxidizing source mounted in the second chamber;
- a transfer arm configured to receive and transfer the cleaved semiconductor structure, defining a first facet, from the first chamber to the second chamber; and
- a fixture adapted to mount the given structure thereon in the second chamber, wherein the fixture is configured to be manipulated to:
   - expose the first facet of the cleaved semiconductor structure in the second chamber to a cleaning beam from the cleaning source, by disposing the first facet opposing the cleaning source,
   - expose the first facet of the cleaved semiconductor structure in the second chamber to heat energy from the heating source, by disposing the first facet opposing the heating source, and
   - expose the first facet of the cleaved semiconductor structure in the second chamber to an oxidation agent from the oxidizing source, by disposing the first facet opposing the oxidizing source.

Embodiments of the present disclosure substantially eliminate or at least partially address the aforementioned problems in the prior art and provide an improved method for passivating a cleaved semiconductor structure for utilization as an edge-emitting laser device.

Additional aspects, advantages, features, and objects of the present disclosure would be made apparent from the drawings and the detailed description of the illustrative embodiments construed in conjunction with the appended claims that follow.

### BRIEF DESCRIPTION OF THE DRAWINGS

Embodiments of the present disclosure will now be described, by way of example only, with reference to the following diagrams wherein:
- FIG. 1A: is a flowchart listing steps involved in a method of passivating a cleaved semiconductor structure for utilization as an edge-emitting laser device, in accordance with an embodiment of the present disclosure;
- FIG. 1B: is a representative flowchart listing steps involved in a method of passivating a cleaved semiconductor structure for utilization as an edge-emitting laser device, in accordance with an embodiment of the present disclosure;
- FIG. 2A: is a representative diagram of an exemplary semiconductor cleaved bar comprising multiple semiconductor structures therein;
- FIG. 2B: is a representative diagram of one of the cleaved semiconductor structure of the semiconductor bar of FIG. 2A;
- FIG. 2C: is an exemplary schematic diagram of a system for passivating the cleaved semiconductor structure for utilization as an edge-emitting laser device;
- FIG. 3A: is a representative diagram of exemplary cleaved semiconductor structure before cleaning a first facet thereof;
- FIG. 3B: is a representative diagram of exemplary cleaved semiconductor structure after cleaning the first facet thereof;
- FIG. 3C: is a representative diagram of exemplary cleaved semiconductor structure with the first facet thereof passivated with an ordered native oxide layer, in accordance with one or more embodiments of the present disclosure;
- FIG. 4A: is a schematic diagram of an exemplary stacking fixture of the system, in accordance with one or more embodiments of the present disclosure;
- FIG. 4B: is a detailed view of an exemplary fixture holding the plurality of cleaved semiconductor structures, in accordance with one or more embodiments of the present disclosure;
- FIG. 5: is a schematic diagram of exemplary second chamber for passivating the cleaved semiconductor structure, in accordance with one or more embodiments of the present disclosure;
- FIG. 6: is a graphical representation of temperature variations in the cleaved semiconductor structure as a measure of distance from the heating source, in accordance with an embodiment of the present disclosure; and
- FIG. 7: is a graphical representation of differentiated scanning tunnelling spectroscopy IV curve with respect to voltage in the cleaved semiconductor structure, in accordance with an embodiment of the present disclosure.

### DETAILED DESCRIPTION OF EMBODIMENTS

The following detailed description illustrates embodiments of the present disclosure and ways in which they can be implemented. Although some modes of carrying out the present disclosure have been disclosed, those skilled in the art would recognize that other embodiments for carrying out or practising the present disclosure are also possible.

In one aspect, an embodiment of the present disclosure provides a method of passivating a cleaved semiconductor structure for utilization as an edge-emitting laser device, the method comprising:
- providing an enclosure having a first chamber and a second chamber, a transfer arm to receive and transfer a given semiconductor structure from the first chamber to the second chamber, and a fixture to mount the given semiconductor structure thereon in the second chamber, and with each of the first chamber and the second chamber adapted to provide vacuum condition inside thereof;
- loading the cleaved semiconductor structure defining a first facet, in the first chamber, onto the transfer arm therein;
- transferring the cleaved semiconductor structure from the first chamber to the second chamber using the transfer arm, to have the cleaved semiconductor structure mounted onto the fixture in the second chamber;
- exposing the first facet of the cleaved semiconductor structure in the second chamber to a cleaning beam from a cleaning source opposing the first facet by manipulating the fixture therein, to remove a possible native oxide layer formed on the first facet of the cleaved semiconductor structure;
- exposing the first facet of the cleaved semiconductor structure in the second chamber to heat energy from a heating source opposing the first facet by manipulating the fixture therein, to heat the first facet of the cleaved semiconductor structure; and
- exposing the first facet of the cleaved semiconductor structure in the second chamber to an oxidation agent from an oxidizing source opposing the first facet by manipulating the fixture therein, to form an ordered oxide layer on the first facet of the cleaved semiconductor structure.

The term *"passivating"* used herein refers to the process of fabrication (or formation) of passivation layer(s) configured to protect internal structure of semiconductor device from contaminants and oxidation. The contamination and oxidation results in defects at the atomic level that will make the semiconductor devices to be less power efficient, and may cause reliability issues, leading to low manufacturing yields, and thus increased costs. Passivation, hence, enables a reduction of the surface defect density to unprecedented levels, thus resulting in a boost of efficiency and an increase in manufacturing yield of III-V semiconductor-based devices. The passivating layer is formed, for example, of an oxide layer and/or a nitride layer onto the cleaved semiconductor structure.

The term *"semiconductor structure"* refers to a layer or block of a material upon or within which elements of a semiconductor device are fabricated or attached. Typically, the semiconductor structure may be a layer of any metallic, non-metallic, semiconductor material or a combination of the metallic, non-metallic and semiconductor material, a layer of any material deposited on a supporting substrate or the supporting structure itself. In present examples, the semiconductor structure, the semiconductor chip, may be GaAs or Indium phosphide (InP) based structure which is suitable for forming the edge-emitting laser device, and other HEMT and MESFET structures. However, the semiconductor structure may be formed of any material on which it is desired to produce a desired pattern (for example, sub-half micron) in accordance with the present disclosure.

The semiconductor structure may be formed using a variety of conventional techniques, integrated circuit, or electronic structure to be formed, including such techniques as molecular beam epitaxy or metal-organic chemical vapor deposition. As may be understood, upon formation of the semiconductor structure, the bars of the semiconductor structure are cleaved via conventional techniques to be further treated via the method for utilization as the edge-emitting laser device. It may be appreciated that multiple cleaved semiconductor structures, the laser chips, may be part of a single semiconductor bar, and the entire semiconductor bar may be processed at a given time, or preferably multiple such stacked semiconductor bars may be processed at a given time, for bulk production and improved efficiency of the method and the system of the present disclosure.

The edge-emitting laser device is fabricated using the cleaved semiconductor structure by implementing the method of the present disclosure, and thereby achieves all features and advantages of the present disclosure. Optionally, the edge-emitting laser device being fabricated on the cleaved semiconductor structure is adapted to provide target lasing properties which term *"lasing properties"* refer to the spectral emission properties and/or characteristics of the laser being produced by the semiconductor device. The target lasing properties of the semiconductor device are adapted based on the implementation by varying the inputs such as, the input current, voltage, power, cavity spacing, and the like to provide a desired lasing action of the semiconductor device.

The method comprises providing an enclosure having a first chamber and a second chamber, a transfer arm to receive and transfer a given semiconductor structure from the first chamber to the second chamber, and a fixture to mount the given structure thereon in the second chamber, and with each of the first chamber and the second chamber adapted to provide vacuum condition inside thereof. The *"enclosure"* refers to an external body comprising a multi-chamber system for inertly storing a given semiconductor structure and preventing exposure from the surroundings. Herein, the enclosure comprises the first chamber, wherein the given semiconductor structure (i.e., the cleaved semiconductor structure) may be loaded or transferred, and the transfer arm configured to transfer or receive the given semiconductor structure to and from the first chamber or the second chamber. Further, the enclosure comprises the fixture configured to mount the given structure (upon being transferred) to the second chamber.

Herein, the term "transfer arm" refers to a manually actuated, or an automatically actuated arm or robotic arm configured to transfer, or reorient a given semiconductor structure and/or fixture to a desired location or orientation within the enclosure. Typically, the transfer arm is a moveable and extendable arm within the enclosure, between the first and second chambers, and enables to pick up the semiconductor structure/fixture in one chamber and transfer it by precise (linear) motion to another chamber, or move in one chamber, while maintaining vacuum integrity.

The term "fixture" refers to a customized support device configured to securely locate, support, and mount the cleaved semiconductor structure and enable external manipulation thereof. In an example, the fixture may be a type of jig (such as, a stacking jig, a plate jig, channel jigs, etc.). In another example, the fixture may be a metallic frame configured to mount multiple cleaved semiconductor structures. Optionally, the fixture may have an opening through which at least one facet of each cleaved semiconductor structure is exposed for treatment. Moreover, it will be appreciated that the fixture may be mounted, with other fixtures having stacked cleaved semiconductor structures thereat, and thereby treated in conjunction as per the method. Beneficially, such an arrangement of the cleaved semiconductor structures improves the efficiency of the method by enabling mass production owing to the higher number of semiconductor structures that may be processed parallelly at a single time via the method. In some embodiments, the semiconductor bar with multiple cleaved semiconductor structures is stacked in the fixture (such as, a stacking jig) on top of each other. For example, such a fixture may include 5, 10, 15, 20, 25, 30, 35, 40, 45, 50, 55, 60, 70, 80, 90 or 100 cleaved (semiconductor) structures stacked on one another to form a semiconductor bar. Optionally, such multiple semiconductor bars may be separated by a spacing structure such as, for example, a GaAs structure, to prevent stacking of the cleaved semiconductor structures to each other, due to presence of contact metals therein.

The method further comprises loading the cleaved semiconductor structure defining a first facet, in the first chamber, onto the transfer arm therein. Typically, the cleaved semiconductor structure defining the first facet is loaded onto a stacking fixture (for example, a stacking jig) and thereby loaded to the first chamber for further transfer and/or operation.

Conventionally, the semiconductor structures are mounted onto a manipulating fixture to be moved between different chambers for exposure to different treatment processes and may even require leaving the enclosure which have inherent risk of exposure to atmosphere. To overcome the aforementioned inefficiency, the present disclosure provides a novel approach in which multiple facets of the semiconductor structures may be exposed, cleaned, heated, passivated and so on, in a single chamber.

The method further comprises transferring the cleaved semiconductor structure from the first chamber to the second chamber using the transfer arm, to have the cleaved semiconductor structure mounted, onto the fixture, in the second chamber. In some examples, during operation, the cleaved semiconductor structure may be first loaded onto the stacking fixture before being loaded in the first chamber, wherein further the entire stacking fixture along with the cleaved semiconductor structure(s) may be transferred using the transfer arm to the second chamber without leaving the enclosure (and thus being exposed to atmosphere) for further processing of the cleaved semiconductor structure loaded therein. Particularly, the semiconductor bar with the plurality of cleaved semiconductor structures is mounted onto the fixture for simultaneous processing of each of the plurality of cleaved semiconductor structures therein. Preferably, multiple such semiconductor bars may be stacked in the fixture for simultaneous processing of the cleaved semiconductor structures, allowing for bulk production and high throughput.

Herein, the cleaved semiconductor structures are mounted on the fixture, such that the first facets of the multiple cleaved semiconductor structures are aligned in the same direction, and the treatment steps of the method affect each of the first facets in a similar manner. Moreover, once the cleaved semiconductor structures are loaded in the first chamber, the cleaved semiconductor structures are transferred to the second chamber, along with the stacking fixture, where the first facet of the cleaved semiconductor structure may be further cleaned and/or passivated, after which the second facet of the semiconductor structure is similarly exposed (by manipulation of the transfer arm) to be heated, cleaned and passivated within the second chamber. Beneficially, during operation, a single chamber i.e., the second chamber is utilized, wherein both facets i.e., the first facet and the second facet, may be treated, cleaned, and passivated without employing any other chambers or leaving the enclosure, during processing, to make the method faster and efficient.

In one or more embodiments, the fixture is adapted to be coupled to the transfer arm and have a plurality of degree-of-freedoms to be manipulated with respect to the transfer arm, and wherein the cleaved semiconductor structure is loaded onto the stacking fixture and thereon in the first chamber. Further, the stacking fixture with the cleaved semiconductor structure loaded thereon is transferred to the fixture in the second chamber for further processing. The fixture is adapted to couple to the transfer arm, wherein the coupling allows a plurality of degree of freedom (DoF) to be manipulated with respect to the transfer arm and thereby enables convenient and efficient transfer and loading of the cleaved semiconductor structures. In an example, the fixture coupled to the transfer arm allows complete freedom of movement along one or more of translation axes x, y, z axis as well as one or more of rotational axis α, β and γ.

The method further comprises exposing the first facet of the cleaved semiconductor structure in the second chamber to a cleaning beam from a cleaning source opposing the first facet by manipulating the fixture therein, to remove a possible native oxide layer formed on the first facet of the cleaved semiconductor structure. It may be appreciated that the contaminants on a given semiconductor structure may seriously impact the yield of manufacturing laser devices during semiconductor fabrication and thus, removal or cleaning of such contaminants from the facets of the given semiconductor structure may be required during passivation of semiconductor structures. Thus, upon transferring the cleaved semiconductor structure to the second chamber, the first facet of the cleaved semiconductor structure is exposed to the cleaning beam from the cleaning source by manipulating the fixture therein.

Herein, the term *"cleaning beam"* refers to the irradiated beam from the cleaning beam source configured to remove (or clean) the surface (or facets) of the cleaved semiconductor structure of any possible oxide layers or other contaminants (such as, dust, rust, grease, etc.). In an example, the method may employ micro pulse lasers or high-power lasers, i.e., short pulse laser having high power, that are able to clean without damaging the surfaces, for removing the native oxide layer. Herein, since the power input (or peak power) to the high-power short pulse laser is extremely high for a shorter duration, the heat-affected zone (HAZ) is lower than other types of lasers and the cleaning process takes lesser time in comparison to other types of lasers. Moreover, beneficially, such an implementation requires only one or two lasers for the entire passivation method. In another example, the method may employ continuous wavelength lasers having different wavelength and powers. In another example, the method may employ an ionic beam for removing the possible native oxide layer. In still other examples, the method may employ continuous wavelength lasers, or pulse lasers of different wavelengths or powers based on the implementation. It will be appreciated that the method may vary the essential laser parameters such as laser intensity, wavelength, pulse duration, pulse width, and incident angle to potentially improve the cleaning effect and may employ any cleaning source and corresponding cleaning beam techniques based on the needs of the implementation.

Such a cleaning step removes any possible contaminants from the first facet of the cleaved semiconductor structure prior to further treatment of the given semiconductor structure. Beneficially, removal of these contaminants and native oxides is essential to allow formation of ordered oxide layer thereon (also known as Kontrox^{®} layer, i.e., a thin long range ordered oxide layer), other oxides films to be deposited and grown on top of the semiconductor structure. As may be appreciated that otherwise it may not be possible to create long range order oxides; as if there are decontaminants, the long-range order oxides formation is not going to succeed. Thus, the decontaminates and native oxides need to be removed. In some examples, the adhesion of oxygen for forming long range order oxides may be aided by providing pre-defined temperature conditions.

In one or more embodiments, the cleaning beam comprises at least one of: atomic beam of hydrogen, argon, xenon, or mixture thereof, ion beam comprising ionized noble gases and/or nitrogen. In some embodiments, the cleaning beam utilized by the present method is an ionic beam comprising ionized noble gases (such as, Helium, Argon, etc.) and/or nitrogen i.e., a beam of energetic ions directed towards the cleaved semiconductor structure for removing any possible contaminants. Notably, the ionized beam has an energy level of 100 electron volts or lower to optimize the cleaning process. In other embodiments, the cleaning beam utilized by the present method is an atomic beam comprising at least one of atomic hydrogen, argon, xenon, or a mixture thereof i.e., a beam of energetic atoms directed towards the semiconductor structure for removing any possible native oxide layers.

The method further comprises exposing the first facet of the cleaved semiconductor structure in the second chamber to heat beam from the heating source opposing the first facet by manipulating the fixture therein, to heat the first facet of the cleaved semiconductor structure. It may be understood that heating can be applied prior, during and/or after the oxidation step. Generally, the cleaved semiconductor structures are heated during the cleaning process, but there are also cases where the heating is not always required during or after oxidation. Herein, the entire fixture may be manipulated or repositioned in order to accommodate (or directly face) the incoming heat beam from the heating source uniformly. Beneficially, the maximum amount of heat beam is received by the exposed first facet of the cleaved semiconductor structure due to the manipulation and thereby, heats the first facet efficiently and accurately due to the higher precision control and increased energy efficiency of the laser radiation.

Herein, the term "heat beam" refers to the irradiated beam from the heat source configured to provide heat energy towards a desired location to heat or clean) the surface (or facets) of the cleaved semiconductor structure of any possible contaminants (such as, moisture). In an example, the method may employ micro pulse lasers or high-power lasers, i.e., short pulse laser having high power, that are able to heat without damaging the surfaces, for heating the first facet of the cleaved semiconductor structure. Herein, since the power input (or peak power) to the high-power short pulse laser is extremely high for a shorter duration, the heat-affected zone (HAZ) is lower than other types of lasers and the heating process takes lesser time in comparison to other types of lasers. In still other examples, the method may employ continuous wavelength lasers, or pulse lasers of different wavelengths or powers based on the implementation. It will be appreciated that the method may vary the essential laser parameters such as laser intensity, wavelength, pulse duration, pulse width, and incident angle to potentially improve the heating effect and may employ any heating source and corresponding heat beam techniques based on the needs of the implementation. In present examples, the heating source may be a type of laser, such as solid-state lasers, gas lasers, and so forth. In some examples, the heating source may be configured to direct the heat beam towards the first facet of the cleaved semiconductor structure to heat the first facet for cleaning and/or removing any potentially present contaminants before further treatment. For example, the heating may remove any moisture, gases, and other contaminants on the cleaned first facet. Notably, the temperature measured in the second chamber during heating may remain constant (for example, room temperature) during operation in contrast to existing systems and processes due to the localized heating effect of the heat beam provided by the heating source i.e., the heat beam is localized only to the exposed first facet of the cleaved semiconductor structure. Beneficially, via such an application of the heating source, the thermal load applied to the whole cleaved semiconductor structure is lower in comparison to prior art, wherein the heating was conducted from the non-exposed facet and thereby prevents the corresponding high risk of damage due to exposure to high temperatures through the whole structure.

The heating source directs the heat beam towards the first facet of the cleaved semiconductor structure to heat the first facet for cleaning and/or removing any potentially present contaminants before further treatment. For example, the heating may remove any moisture, gases, and other contaminants on the cleaned first facet. The temperature measured in the second chamber during heating remains substantially constant (for example, room temperature) during heating, wherein the exposure to the radiation (either IR or laser radiation) is localized to the exposed first facet and may be varied or for different periods of time. For example, the first facet of the cleaved semiconductor structure may be heated for 5 minutes, 10 minutes, 15 minutes, 20 minutes, 30 minutes, 60 minutes and so forth. It will be appreciated by a person skilled in the art that the pressure, temperature, and exposure duration may be varied based on the implementation without limiting the scope of the present disclosure.

Optionally, the heat beam is provided by at least one of: laser irradiation, infrared radiation. Alternatively stated, the heating source utilized for providing the heat beam to heat the first facet of the cleaved semiconductor structure is a laser source i.e., irradiation via lasers (for example, solid-state lasers, gas lasers, semiconductor lasers), or an infrared source i.e., radiation from an infrared (IR) light source (such as, an IR lamp). The IR light or the laser radiation heats the cleaved semiconductor structure to remove moisture and contaminants (e.g., adsorbed particles, N₂, CO₂, or O₂, among other contaminants) that have physically adsorbed to the surface of the first facet subsequent to cleaving. Beneficially, the laser radiation provides high accuracy and precision control of the heat beam output and results in minimal distortion and/or stress to the cleaned first facet during operation, whereas the infrared radiation improves the efficiency of the method owing to the lower energy consumption.

In one or more embodiments, the heating source is mounted externally to the second chamber, and the method further comprises providing a transparent viewport to allow the heat beam from the heating source to reach the cleaved semiconductor structure. The term "viewport" refers to an access port configured to allow the heat beam from the heating source to reach the exposed first facet of the cleaved semiconductor structure i.e., after, or during, the cleaning and/or oxidation process. It will be appreciated that based on the needs of the implementation, the location of the heating source and/or the beam shaper may be varied i.e., may be mounted externally or internally to the second chamber or the enclosure. In some examples, the heating source and/or the beam shaper employed by the method may be located inside the enclosure while internally mounted to the first and/or second chamber to reduce the physical footprint of the implementation. In the present examples, the heating source and/or the beam shaper employed by the method may be located inside the enclosure while externally mounted to the first and/or second chambers, or outside the enclosure altogether, and accessible through an entry or access port i.e., the transparent viewport.

The method further comprises exposing the first facet of the cleaved semiconductor structure in the second chamber to an oxidation agent from an oxidizing source opposing the first facet by manipulating the fixture therein, to form a long range ordered oxide layer on the first facet of the cleaved semiconductor structure. That is, during or upon, heating the cleaned first facet of the cleaved semiconductor structure, the method further comprises exposing the heated first facet to the oxidation agent, from the oxidizing source, to form the ordered oxide layer by manipulating the fixture in the second chamber. Conventionally, existing methods or systems have utilized the materials from the III-V group that result in natural amorphous native oxides. However, such materials are known to provide non-ordered native oxides that provide low-quality oxides and thereby resulting a poorer quality laser device. To overcome the aforementioned problem, the present method involves controlling the oxidation step i.e., the formation of the ordered oxide layer, by controlling various operational parameters such as, pressure, temperature, amount of oxidizing agent used, and application time, to form the long-range ordered oxides i.e., the ordered oxide layer. That is, the method involves transforming the cleaned first facet of the semiconductor structure into the ordered oxide layer exhibiting long-range order using the oxidizing source.

Herein, the *"ordered oxide layer"* refers to a thin ordered layer of an oxide, such as, any native oxide, or any other oxides, wherein the oxide layer may be protective, decorative, or functional in nature. The ordered oxide layer acts as a passivating layer on the surface of the cleaved semiconductor structure and prevents external effects (such as, corrosion) from exposure to surroundings. Such ordered oxide layer thus provides an increase in energy barrier for the edge-emitting laser device for improving carrier confinement within the stacked configuration of the plurality of cleaved semiconductor structures. Herein, the atomic positions of the ordered oxide layer exhibit a long-range order or translational periodicity; wherein, for example the positions of the III - V atoms in the ordered oxide layer repeat in space in a regular array. Moreover, the ordered oxide layer may be a crystalline layer having both long range order and short-range order without any limitations to the present disclosure. It will be appreciated by a person skilled in the art that the ordered oxide layer is formed by oxidizing the cleaned first facet of the cleaved semiconductor structure (and not particularly by deposition of any additional oxides such as, via conventional deposition techniques).

Moreover, the crystal symmetry of the ordered oxide layer can be the same or can differ from the crystal structure of the III-V semiconductor material. Some III-V materials have more than one possibility for a crystalline oxide structure. The different structures can be achieved by doing the transformation of the III-V semiconductor surface in different temperature, oxygen dose, oxygen flux, partial pressure of oxygen, and/or duration of the treatment. The edge emitting laser device formed from the present cleaved semiconductor structure includes the ordered oxide layer. As discussed later in detail, the introduction of the ordered oxide layer may cause an increase in the energy band gap, in the semiconductor device. Beneficially, the higher energy gap gives the edge-emitting laser devices the ability to operate at higher temperatures, as otherwise the energy bandgaps typically shrink with increasing temperature which presents problems during operation of conventional semiconductors.

In one or more embodiments, the oxidation agent comprises at least one of: molecular oxygen, oxygen plasma, ozone, NOₓ, CO. The oxidation agent is selected based on the material of the cleaved semiconductor structure, the operational conditions in order to optimize the efficiency of the method and may vary based on the implementation without limiting the scope of the present disclosure. For example, any other oxidation agent such as, other oxygen containing gases (such as, chlorine dioxide, carbon dioxide), other halogens (such as, chlorine, fluorine, bromine, etc.). Herein, the oxygen source may produce the molecular oxygen and/or the ozone molecules by spontaneous oxidation of oxygen molecules in air (e.g., thermally dissociating oxygen via ultra-violet radiation, or corona discharge, etc.) or by atomic dissociation using an oxygen plasma within the second chamber. Beneficially, such a process of ordered oxide layer formation generates an effective passivation layer that is thermodynamically stable and prevents any further un-wanted oxidation. As a result, the number of defect states are reduced and thereby preventing further COMD, and results in an improved device lifetime, wherein the clean first facet of the cleaved semiconductor is utilized for obtaining high quality single crystalline growth of the ordered oxide layer.

In one or more embodiments, the method further comprises, prior to exposing the first facet to the oxidation agent from the oxidizing source, exposing the first facet of the cleaved semiconductor structure in the second chamber to group III atoms from a deposition source opposing the first facet by manipulating the fixture therein, to deposit the group III atoms on the first facet of the cleaved semiconductor structure. Typically, prior to forming the ordered oxide layer on the heated first facet of the cleaved semiconductor structure, the method further comprises depositing the group III atom(s) i.e., at least one of Boron (B), Aluminium (Al), Gallium (Ga), Indium (In) and Thallium (TI) over the first facet of the cleaved semiconductor structure. Beneficially, the deposited layer acts as an additional passivation layer and further prevents any potential damage due to exposure to surroundings (such as, corrosion, erosion, etc.) and thereby improves the lifetime of the edge-emitting laser device utilizing the cleaved semiconductor structure.

In one or more embodiments, the method further comprises depositing a layer of at least one of Si, a-Si:H, SiO₂, SiNₓ, over the ordered oxide layer formed on the first facet of the cleaved semiconductor structure. Typically, upon forming the ordered oxide layer on the first facet of the cleaved semiconductor structure, the method further comprises depositing a layer of amorphous silicon, or silicon dioxide, or silicon nitrides, over the ordered oxide layer. Herein, the deposited layer acts as an insulating layer configured to provide more stability to passivation and thereby preventing deterioration of the passivation layer and providing additional protection therefor. Moreover, upon depositing over the ordered oxide layer, it prevents any further oxidation due to potential oxidation at the surface due to exposure to external surroundings such as, humidity from the atmosphere, and thereby eliminating the possible problems. It will be appreciated that the selection of the deposition layer is based on the implementation and may be varied without limiting the scope of the present disclosure. For example, sapphire may be used for high-performance radio frequency (RF) and radiation-sensitive applications, and silicon dioxide for diminished short-channel effects in other microelectronics devices.

In one or more embodiments, a plurality of cleaved semiconductor structures are loaded in the first chamber, being stacked on top of each other at respective side facets thereof, with the first facet being orthogonal to the corresponding side facet in the respective cleaved semiconductor structure, and wherein the method further comprises manipulating the fixture in the second chamber to expose the first facet of each of the cleaved semiconductor structure of the plurality of cleaved semiconductor structures to one or more of the cleaning beam from the cleaning source, the heat beam from the heating source and the oxidation agent from the oxidizing source. That is, in embodiments wherein the plurality of cleaved semiconductor structures is loaded in the first chamber, each of the subsequent (apart from the first structure in each stack) cleaved semiconductor structures are stacked on top of each other at the respective side facets thereof. Herein, the fixture is configured to securely locate, support, and mount the plurality of cleaved semiconductor structures and enable external manipulation thereof. Moreover, it will be appreciated that the fixture may be mounted, with other fixtures having stacked cleaved semiconductor structures thereat, and thereby treated in conjunction via the method. Beneficially, such an arrangement of the cleaved semiconductor structures improves the efficiency of the method by enabling mass production owing to the higher number of semiconductor structures that may be processed parallelly at a single time via the method. In some embodiments, the cleaved semiconductor structures are mounted on the fixture (such as, a stacking jig) on top of each other and provided to the second chamber. For example, such fixtures may include 5, 10, 15, 20, 25, 30, 35, 40, 45, 50, 55, 60, 70, 80, 90 or 100 cleaved semiconductor structures stacked on one another and provided to the second chamber. Optionally, the cleaved semiconductor structures may be separated by a spacing structure such as, for example, a GaAs structure. Further, the method comprises manipulating the fixture in the second chamber i.e., repositioning and/or reorienting the fixture containing the cleaved semiconductor structures to expose the first facets of each cleaved semiconductor structure to one or more of the cleaning beams from the cleaning source, the heat beam from the heating source and the oxidation agent from the oxidizing source.

In one or more embodiments, the cleaved semiconductor structure further defines a second facet therein, and wherein the method further comprises manipulating the fixture in the second chamber to expose the second facet of the cleaved semiconductor structure to one or more of the cleaning beams from the cleaning source, the heat beam from the heating source and the oxidation agent from the oxidizing source in the second chamber, without removing the semiconductor structure from the enclosure. It is preferable, in some implementations, to form the passivation layer on both opposing facets of the cleaved semiconductor structure i.e., the first facet and the second facet, to prevent contaminants and amorphous oxide layer formation thereat. Herein, to form the passivation layer on the second facet, the orientation of the cleaved semiconductor structure within the second chamber is modified by manipulating the fixture such that the second facet may be exposed to one or more of the cleaning beams from the cleaning source, the heat beam from the heating source and the oxidation agent from the oxidizing source in the second chamber. In contrast to conventional techniques, the configuration of the transfer arm and the fixture allows the second facet to be exposed to the said process(es) without the need to remove the semiconductor structure from the enclosure.

Optionally, the method further comprises manipulating the fixture to expose the second facets of the stacked semiconductor structures, wherein manipulating the fixture involves reorienting or repositioning the fixture, comprising the mounted cleaved semiconductor structures, from a first orientation to a second different orientation within the second chamber such that the second facet are exposed to further treatment. Beneficially, the passivation of both the facets of the cleaved semiconductor structures provides greater level of protection and thus effectively prevent contaminants from depositing on the cleaned facets and prevents the re-formation of the amorphous oxide layers. Additionally, passivating both the facets of the cleaved semiconductor structures improves the tolerance to withstand high temperatures and thereby leads to an improved laser device lifetime.

The present disclosure also provides a system for passivating a cleaved semiconductor structure for utilization as an edge-emitting laser. The various embodiments and variants disclosed above apply *mutatis mutandis* to the present system without any limitations.

The system comprises an enclosure having a first chamber and a second chamber, and a pump configured to generate vacuum condition inside each of the first chamber and the second chamber. The *"pump"* as used herein refers to a vacuum pump configured to draw gas molecules from an enclosed space (such as, the enclosure, the first chamber, the second chamber) to create a partial vacuum i.e., to generate vacuum conditions inside the said chambers. For example, the pump may be selected from at least one of, but not limited to, positive displacement pumps, regenerative pumps, entrapment pumps.

The system further comprises a cleaning source and an oxidizing source mounted in the second chamber. In particular, the system comprises a first port for mounting the cleaning source in the second chamber and a second port for mounting the oxidizing source in the second chamber. The term *"port"* refers to an aperture or opening that extends through a wall of the enclosure, wherein the shape, size and curvature of the ports may be varied as per the requirements of the implementation. In one or more embodiments, the cleaning source comprises at least one of: a radiofrequency (RF) plasma source, an ion sputtering source, wherein the selection of the cleaning source is done based on the implementation to optimize the method. In one or more embodiments, the oxidizing source comprises a radiofrequency (RF) plasma source. It will be appreciated that other oxidizing sources may also be used including, but not limited to, a mass-flow-controller, a vacuum leak-valve, and the like, without limiting the scope of the disclosure.

In one or more embodiments, the system further comprises a heating source mounted in the second chamber. In particular, the system comprises a third port for mounting the heating source in the second chamber. Herein, the heating source is configured to expose the first facet of the cleaved semiconductor structure to heat beam from the heating source, by disposing the first facet opposing the heating source. The second or the third port may be advantageously dimensioned to effectively accommodate the heating source or the oxidizing source, respectively. In one or more embodiments, the heating source comprises at least one of: a laser, an infrared lamp. The selection of the heating source may be done based on the material of the cleaved semiconductor structure and the conditions thereat to perform the heating step effectively and efficiently. In the present embodiments, the heating source is configured to provide the directed heat beam by at least one of: laser irradiation, infrared radiation.

In one or more embodiments, the system further comprises a deposition source mounted in the second chamber. In particular, the system comprises a fourth port for mounting the deposition source in the second chamber, wherein the fixture is further configured to be manipulated to expose, prior to exposing the first facet to the oxidation agent from the oxidizing source, the first facet of the cleaved semiconductor structure in the second chamber to group III atoms from the deposition source, by disposing the first facet opposing the deposition source. The *"deposition source"* refers to a system or a device configured to deposit a thin layer of a material (such as, group III atoms) on the facets of the cleaved semiconductor structure. For example, the deposition source is a thermal vaporization source. In one or more embodiments, the deposition source comprises at least one of: an effusion cell, an electron-beam-evaporator, a gas dispensing unit (for example, for gas precursors as used in techniques such as, molecular metal-organic chemical vapour deposition (MOCVD) and atomic layer deposition (ALD)). Herein, prior to exposing the first facet to the oxidation agent from the oxidizing source, the fixture is manipulated by disposing the first facet opposing the deposition source to effectively accommodate the incoming group III atoms.

In one or more embodiments, the system further comprises a monitoring equipment mounted in the second chamber. In particular, the system comprises a fifth port for mounting a monitoring equipment in the second chamber, wherein the fixture is further configured to be manipulated to expose the first facet of the cleaved semiconductor structure in the second chamber to allow for monitoring a surface crystal structure by the monitoring equipment, by disposing the first facet opposing the monitoring equipment. Typically, to monitor and analyse the surface crystal structure, the system comprises the fifth port configured to mount the monitoring equipment in the second chamber, wherein the fixture is manipulated such that the first facet of the cleaved semiconductor structure is disposed opposing to the monitoring equipment for effective monitoring and analysis.

In one or more embodiments, the monitoring equipment comprises at least one of: a high energy electron diffraction (RHEED) equipment, a low energy electron diffraction (LEED) equipment, an auger electron spectroscopy (AES) equipment, a residual gas analysis (RGA) equipment. Generally, the method may employ any suitable monitoring technique or device such as, an imaging equipment (for example, high-definition camera, Light Detection and Ranging equipment, hyperspectral imaging equipment, and the like), diffraction equipment (for example, LEED), spectroscopy equipment (for example, AES), and the like to monitor the surface crystal structure in an effective manner. Such monitoring equipment provide a detailed analysis of the facets and thereby enables the system to derive meaningful observations therein in order to optimize the system and method. For example, for monitoring effect of temperature on performance of cleaved semiconductor structure or the edge-emitting laser device.

The system further comprises a transfer arm configured to receive and transfer the cleaved semiconductor structure, defining a first facet, from the first chamber to the second chamber and a fixture adapted to mount the given structure thereon in the second chamber, wherein the fixture is configured to be manipulated to expose the first facet of the cleaved semiconductor structure in the second chamber to a cleaning beam from the cleaning source, by disposing the first facet opposing the cleaning source, expose the first facet of the cleaved semiconductor structure in the second chamber to heat beam from the heating source, by disposing the first facet opposing the heating source, and expose the first facet of the cleaved semiconductor structure in the second chamber to an oxidation agent from the oxidizing source, by disposing the first facet opposing the oxidizing source.

The system further comprises a gate valve to control the conditions inside the enclosure and a controller configured to manipulate the fixture and control the movement and/or position of the transfer arm and the fixture, by transmitting command signals to each of the transfer arm and the fixture, for transfer of the semiconductor structure from the first chamber to the second chamber. Said controller may be operatively coupled to the gate valve, the transfer arm, and/or the fixture. Herein, the gate valve is configured to maintain the conditions of the enclosure, unless the controller transmits a command signal to open the gate valve for transfer of the semiconductor structure from the first chamber to the second chamber.

The term *"controller"* as used herein refers to a structure and/or module that includes programmable and/or non-programmable components configured to store, process and/or share information and/or signals for controlling the transfer arm and/or the fixture. The controller may be having elements, such as a display, control buttons or joysticks, processor, memory, and the like.

In one or more embodiments, the cleaved semiconductor structure comprises III-V compound semiconductor materials, and wherein the ordered oxide layer comprises group III and group V oxide bonds forming a structure with long range order. In one or more embodiments, thickness of the ordered oxide layer is less than 10 nm.

### DETAILED DESCRIPTION OF THE DRAWINGS

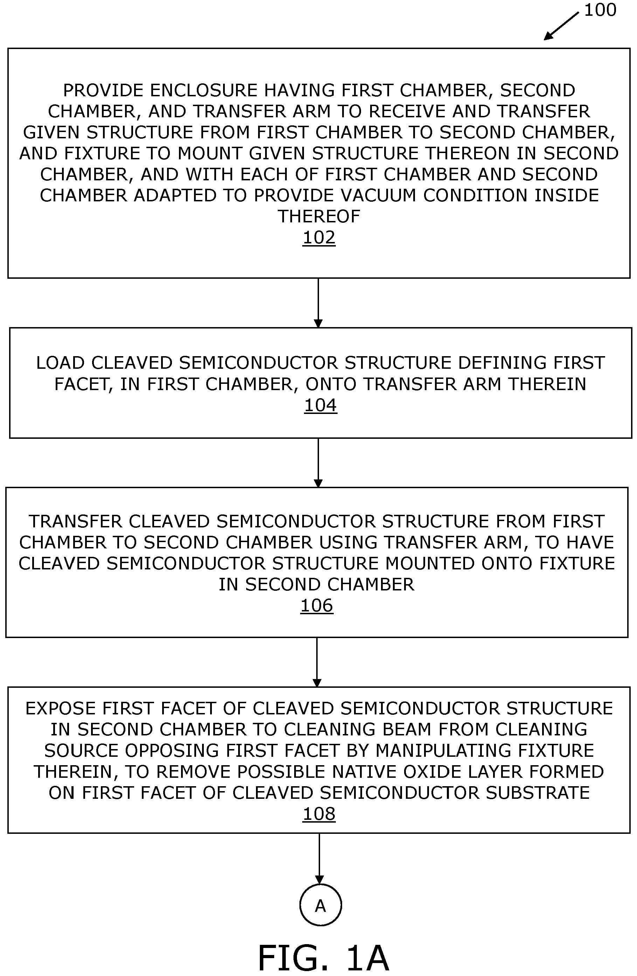

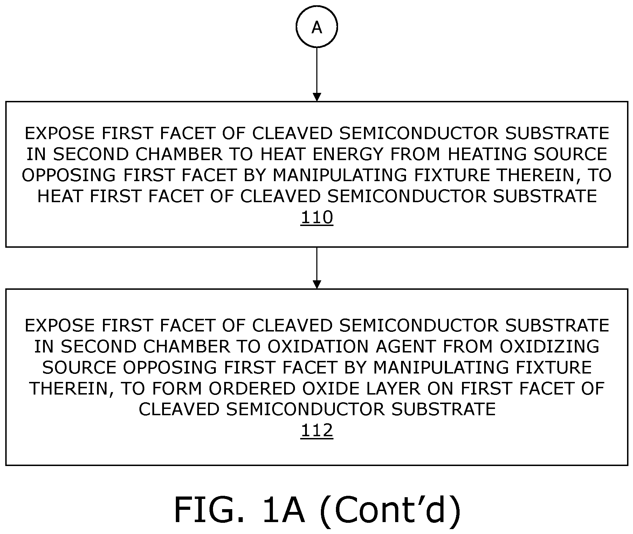

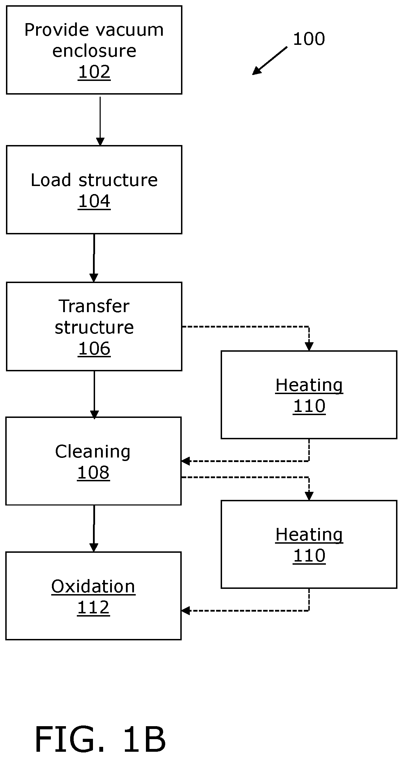

Referring to FIG. 1, illustrated is a flowchart illustrating steps involved in a method **100** of passivating a cleaved semiconductor structure for utilization as an edge-emitting laser device, in accordance with an embodiment of the present disclosure. As shown, the method **100** comprises the steps **102, 104, 106, 108,** and **110.** The listed steps **102, 104, 106, 108,** and **110** may not necessarily be performed in sequential order.

At a step **102,** the method **100** comprises providing an enclosure having a first chamber and a second chamber, a transfer arm to receive and transfer a given structure from the first chamber to the second chamber, and a fixture to mount the given structure thereon in the second chamber, and with each of the first chamber and the second chamber adapted to provide vacuum condition inside thereof. Herein, the vacuum conditions are provided (such as, via a pump) inside each of the first and the second chamber to prevent external exposure to surroundings during processing and/or treatment of the cleaved semiconductor structure and prevent damage thereof (such as, due to COMD, corrosion).

At a step **104,** the method **100** further comprises loading the cleaved semiconductor structure defining a first facet, in the first chamber, onto the transfer arm therein.

At a step **106,** the method **100** further comprises transferring the cleaved semiconductor structure from the first chamber to the second chamber using the transfer arm, to have the cleaved semiconductor structure mounted onto the fixture in the second chamber. Upon loading the cleaved semiconductor structure, the method **100** further comprises transferring the cleaved semiconductor structure via the transfer arm from the first chamber to the second chamber and thereby have the have the cleaved semiconductor structure mounted onto the fixture in the second chamber for further treatment and/or processing steps.

At a step **108,** the method **100** further comprises exposing the first facet of the cleaved semiconductor structure in the second chamber to a cleaning beam from a cleaning source opposing the first facet by manipulating the fixture therein, to remove a possible native oxide layer formed on the first facet of the cleaved semiconductor structure. Upon transferring the cleaved semiconductor structure in the second chamber, the method **100** further comprises cleaning the first facet of the cleaved semiconductor structure by manipulating the fixture therein and exposing the first facet to the cleaning beam to remove a possible native oxide layer formed on the first facet of the cleaved semiconductor structure, wherein the fixture is manipulated for positioning the cleaning source opposing the first facet.

At a step **110,** the method **100** further comprises exposing the first facet of the cleaved semiconductor structure in the second chamber to heat beam from a heating source opposing the first facet by manipulating the fixture therein, to heat the first facet of the cleaved semiconductor structure. Herein, upon, during, or before cleaning the first facet of the cleaved semiconductor structure; and, upon, during, or before exposing the first facet of the cleaved semiconductor structure in the second chamber to the oxidation agent, the first facet is exposed to heat beam from the heating source, for example to remove any remaining contaminants such as, moisture from the first facet prior to further treatment and/or to compliment with the oxidation process.

And, at a step **112,** the method **100** further comprises exposing the first facet of the cleaved semiconductor structure in the second chamber to an oxidation agent from an oxidizing source opposing the first facet by manipulating the fixture therein, to form an ordered oxide layer on the first facet of the cleaved semiconductor structure. Upon heating the first facet of the cleaved semiconductor structure, the method **100** further comprises forming the ordered oxide layer that acts as the passivating layer on the first facet of the cleaved semiconductor structure to prevent potential damage from exposure to surroundings such as, COMD, corrosion and thereby improve the lifetime and reliability of the edge-emitting laser device.

Referring to FIG. 1B, illustrated is a representative flowchart of the method **100** for passivating the cleaved semiconductor structure, in accordance with some embodiments of the present disclosure. As shown, the heating step i.e., the step **110** can be performed at various stages (or steps) of the method **100.** Specifically, after transferring the loaded semiconductor structure **202** onto the second chamber **208,** the heating step **110** may be performed simultaneously while cleaning the first facet **202A** (i.e., during cleaning step **108)** or while forming the ordered oxide layer **236** thereon (the oxidation step **112),** and/or the heating step **110** may be performed before or after cleaning of the first facet **202A** (i.e., after cleaning step **108)** and formation of the ordered oxide layer **236.**

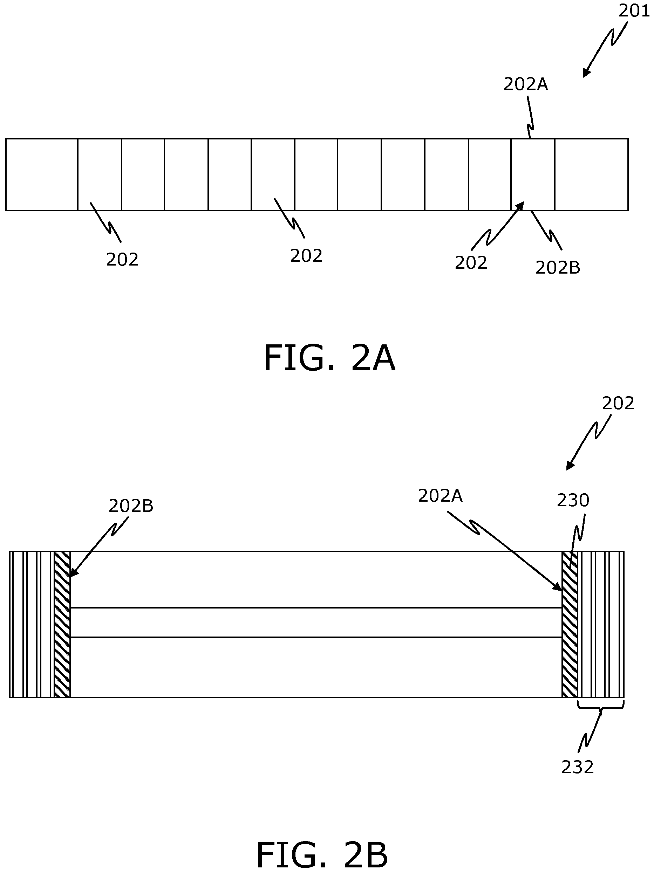

Referring to FIG. 2A, illustrated is a representative diagram of an exemplary semiconductor bar **201** comprising multiple cleaved semiconductor structures **202** therein, in accordance with an embodiment of the present disclosure. As shown, the semiconductor bar **201** comprises a plurality of cleaved semiconductor structures **202** arranged next to each other. Further, as shown, each cleaved semiconductor structure **202** has a first facet **202A** and a second facet **202B.** Herein, the semiconductor bar **201** is treated as per the method **100** (described above), wherein the cleaved semiconductor structures **202** are stacked to dispose the first facet **202A** and/or the second facet **202B** to described exposure processes to enable uniform treatment of the cleaved semiconductor structures **202.** Alternatively stated, the exposed first facet **202A** can be heated at all times i.e., before, during, or after cleaning step **208** and/or oxidation step **212.**

Referring to FIG. 2B, illustrated is a representative diagram of one of the exemplary cleaved semiconductor structures **202,** in accordance with an embodiment of the present disclosure. As shown, the cleaved semiconductor structure **202** provides the first facet **202A** and the second facet **202B** on opposing sides thereof. Further, the cleaved semiconductor structure **202** comprises a deposited passivating layer **230** (for example, group III atomic layer) deposited on each of the first and second facets **202A, 202B** for protection from potential damage from COMD, corrosion, and the like. Furthermore, the cleaved semiconductor structure **202** comprises deposited first layers **232** on each of the first and second facets **202A, 202B** for added protection from exposure to surroundings and thereby protecting the cleaved semiconductor structure **202** from damage effectively. For example, the deposited first layers **232** are metallic coatings. In another example, the deposited first layers **232** are mirror coatings.

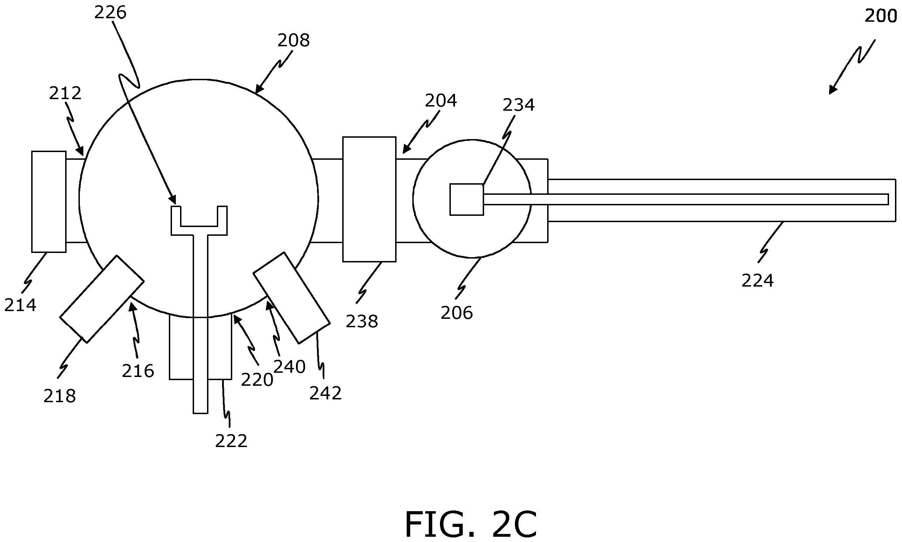

Referring to FIG. 2C, illustrated is an exemplary schematic diagram of a system **200** for passivating the cleaved semiconductor structure **202** (as shown in FIGs. 2A and 2B) for utilization as an edge-emitting laser device, in accordance with an embodiment of the present disclosure. As shown, the system **200** comprises an enclosure **204** having a first chamber **206,** a second chamber **208,** and a pump **210** (not shown) configured to generate vacuum condition (e.g., to ultra-high vacuum (UHV) level) inside each of the first chamber **206** and the second chamber **208.** The system **200** further comprises a stacking fixture **234** configured to hold the plurality of cleaved semiconductor structures **202.** The system **200** further comprises a first port **212** for mounting a cleaning source **214** in the second chamber **208,** a second port **216** for mounting an oxidizing source **218** in the second chamber **208.** The system **200** further comprises a gate valve **238** for isolating the first chamber **206** from the second chamber **208,** to prevent losing ultra-high vacuum (UHV) level in the second chamber **208** when the first chamber **206** is being opened. Typically, the gate valve **238** is configured to isolate the first chamber **206** from the second chamber **208,** when the first chamber **206** is to be opened, to prevent the loss of the vacuum level or conditions in the second chamber **208.** The gate valve **238** is closed such that the second chamber **208** may not lose the vacuum level or conditions when the first chamber **206** may be opened for loading the semiconductor bar **201** with the multiple cleaved semiconductor structures **202** therein.

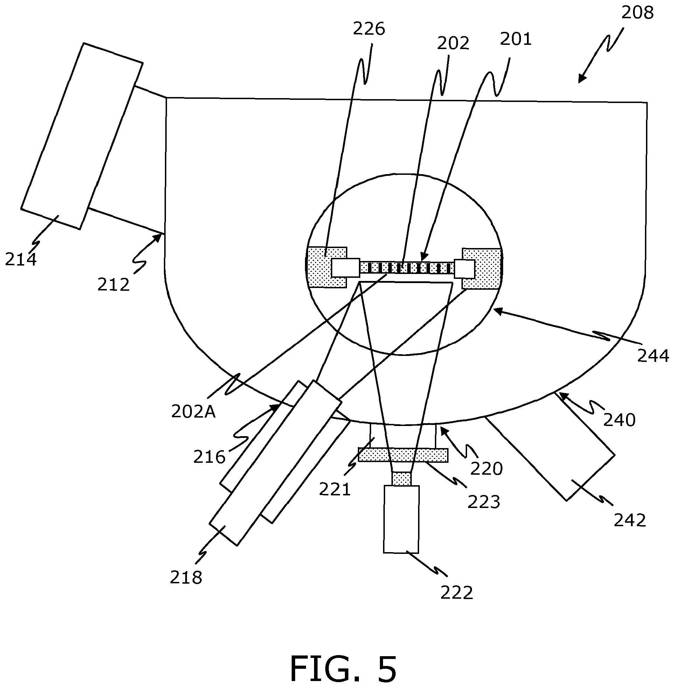

The system **200** further comprises a heating source **222** mounted in the second chamber **208.** In particular, as shown, the system **200** comprises a third port **220** for mounting the heating source **222** in the second chamber **208.** Herein, the fixture **226** is configured to be manipulated to expose the first facet **202A** of the cleaved semiconductor structure **202** in the second chamber **208** to heat beam from the heating source **222** by disposing the first facet **202A** opposing the heating source **222.** Herein, the heat beam may be provided by the heating source **222** either during, before, or after the cleaning and/or oxidation process. As shown, the heating source **222** is a frontal irradiation source, such as a laser, that is mounted externally to the second chamber **208.** Therefore, the system **200** comprises a transparent viewport **221** (as shown in FIG. 5) to allow the heat beam from the heating source **222** to reach the cleaved semiconductor structure **202** in an efficient manner. Further, the system **200** comprises a beam shaper **223** (as shown in FIG. 5) to shape the heat beam from the heating source **222** to be directed (shaped accordingly) to the exposed facet of the cleaved semiconductor structure **202** mounted in the second chamber **208** (as discussed in detail in the proceeding paragraphs).

Further, as shown in FIG. 2C, the system **200** further comprises a transfer arm **224** configured to receive and transfer the cleaved semiconductor structure **202** from the first chamber **206** to the second chamber **208** and a fixture **226** adapted to mount the given structure **202** thereon in the second chamber **208,** wherein the fixture **226** is configured to be manipulated to expose the first facet **202A** (as shown in FIGs. 2A and 2B) and/or the second facet **202B** (as shown in FIGs. 2A and 2B) of the cleaved semiconductor structure **202** in the second chamber **208** to a cleaning beam from the cleaning source **214** by disposing the first facet **202A** opposing the cleaning source **214** and expose the first facet **202A** of the cleaved semiconductor structure **202** in the second chamber **208** to an oxidation agent from the oxidizing source **218** by disposing the first facet **202A** opposing the oxidizing source **218.** In some examples, the system **200** further comprises a mounting jig or a stacking jig **234** located in the first chamber **206** onto which the cleaved semiconductor structure **202** may first be loaded in the system **200,** and from which the cleaved semiconductor structure **202** may be transferred by the transfer arm **224** from the first chamber **206** to the second chamber **208** to be loaded onto the fixture **226** therein.

The system **200** further comprises a deposition source **242** mounted in the second chamber **208.** In particular, as shown, the system **200** comprises a fourth port **240** for mounting the deposition source **242** in the second chamber **208.** Herein, the fixture **226** is configured to be manipulated to expose, prior to exposing the first facet **202A** to the oxidation agent from the oxidizing source **218,** the first facet **202A** of the cleaved semiconductor structure **202** in the second chamber **208** to group III atoms from the deposition source **242,** by disposing the first facet **202A** opposing the deposition source **242.** The system **200** further comprises a monitoring equipment (not shown). The monitoring equipment is contoured to be utilized to provide visibility for observation and/or monitoring of the surface of the cleaved semiconductor structure **202** in the second chamber **208.** For this purpose, as shown in FIG. 5, the system **200** further comprises a fifth port **244** in the form of a transparent viewport to allow the monitoring equipment, that is mounted externally, to be used to observe the cleaved semiconductor structure **202** inside the second chamber **208.**

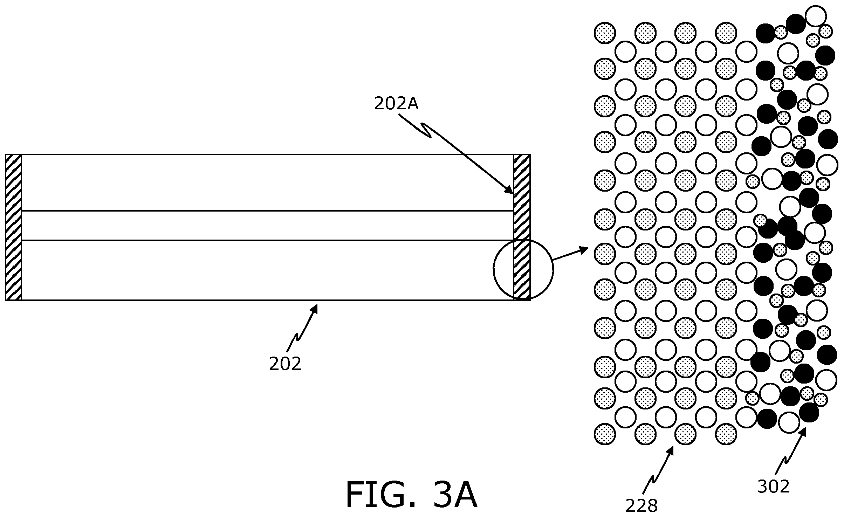

Referring to FIG. 3A, illustrated is a representative diagram of an exemplary cleaved semiconductor structure **202** before cleaning the first facet **202A** therein. As shown, the first facet **202A** comprises the crystalline layer **228** thereon, wherein the crystalline layer **228** is formed via group III to group V atoms. Further, the first facet **202A** has an amorphous oxide layer **302** contaminating the first facet **202A** of the cleaved semiconductor structure **202.** Thus, upon transferring the cleaved semiconductor structure **202** to the second chamber **208,** the first facet **202A** of the cleaved semiconductor structure **202** is exposed to the cleaning beam from the cleaning source **214** by manipulating the fixture **226** to remove the amorphous oxide layer **302** thereof. Beneficially, such a cleaning step removes the amorphous oxide layer **302** from the first facet **202A** of the cleaved semiconductor structure **202** prior to further treatment in an a quick, accurate and efficient manner.

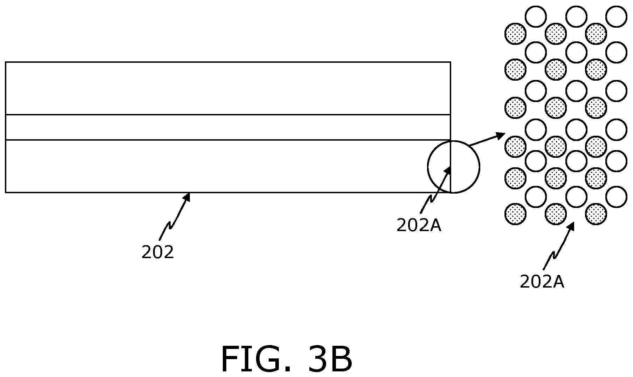

Referring to FIG. 3B, illustrated is a representative diagram of an exemplary cleaved semiconductor structure **202** after cleaning the first facet **202A** of the cleaved semiconductor structure **202.** As shown, upon cleaning the first facet **202A** of the cleaved semiconductor structure **202,** the amorphous oxide layer **302** is removed from the first facet **202A** of the cleaved semiconductor structure **202** and may thereafter be treated with other deposition or cleaning techniques as per requirement.

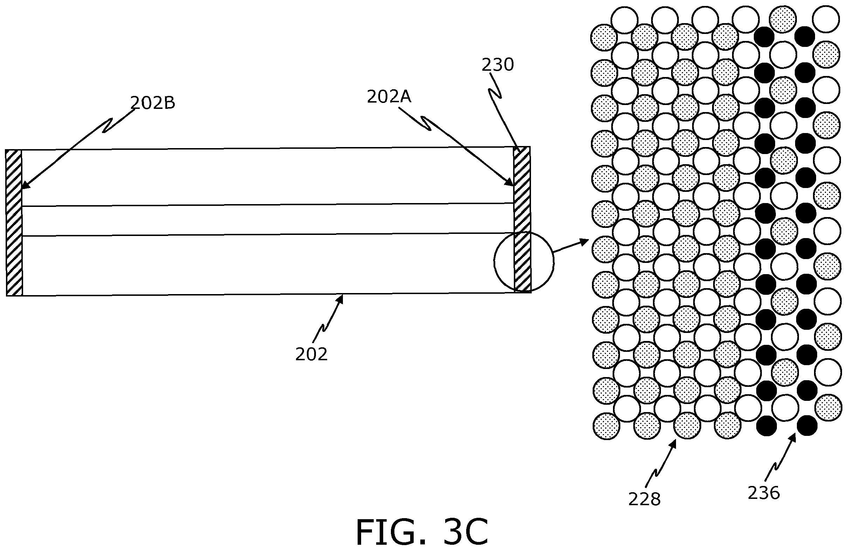

Referring to FIG. 3C, illustrated is a representative diagram of an exemplary cleaved semiconductor structure **202** after cleaning the first facet **202A** of the cleaved semiconductor structure **202** and provided with an ordered oxide layer **236** formed thereon. Herein, the oxidizing source **218** is configured to form the ordered oxide layer **236** via controlled oxidation onto the crystalline layer **228** formed on the first facet **202A,** wherein the fixture **226** is configured to be manipulated to expose the oxidation agent from the oxidizing source **218** to generate the ordered oxide layer **236.**

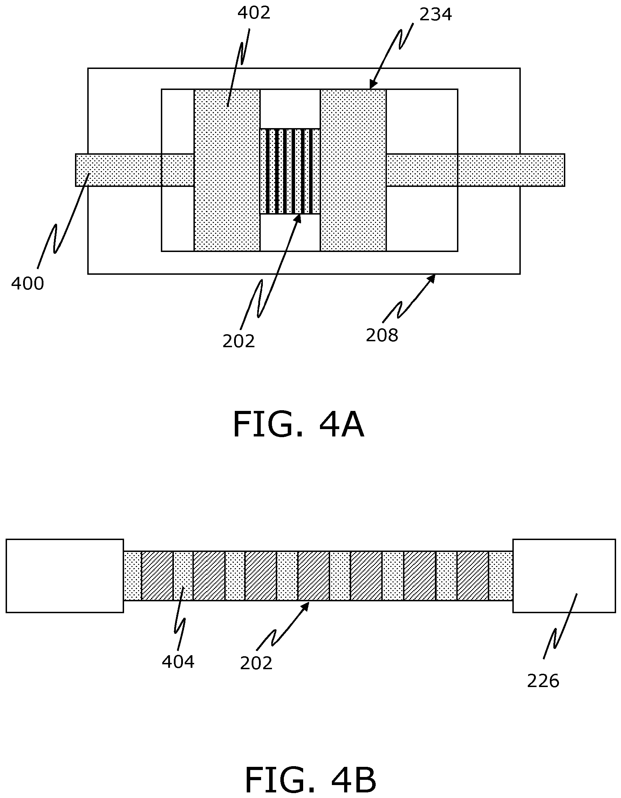

Referring to FIG. 4A, illustrated is a schematic diagram of an exemplary stacking fixture **234,** in accordance with one or more embodiments of the present disclosure. As shown, the stacking fixture **234** is configured for holding or stacking the plurality of cleaved semiconductor structures **202** therein. The stacking fixture **234** comprises either screws or springs **400** configured to push the clamps **402** against each other, adding a suitable pressure to keep the plurality of semiconductor structures **202** "sandwiched" between the clamps **402.** Referring to FIG. 4B, illustrated is a detailed view of an exemplary fixture **226** holding the plurality of cleaved semiconductor structures **202** in the second chamber **208.** As shown, each of the plurality of cleaved semiconductor structures **202** is spaced apart by a spacing element **404** to isolate and protect the contacts of each of the cleaved semiconductor structures **202,** so that contacts of two adjacent cleaved semiconductor structures **202** are not touching each other directly, as they could melt, etc. The spacing element **404** may be GaAs, Sapphire, and the like.

Referring to FIG. 5, illustrated is a schematic diagram of the exemplary second chamber **208** for passivating the cleaved semiconductor structure **202,** in accordance with one or more embodiments of the present disclosure. As shown, the plurality of cleaved semiconductor structures **202** are mounted onto the fixture **226** inside in the second chamber **208.** Herein, via manipulating the fixture **226,** the cleaning source **214** is exposed to a given facet (such as, the first facet **202A)** to remove an amorphous oxide layer (such as, the amorphous oxide layer **302** shown in FIG. 3A) from the exposed facet of the cleaved semiconductor structure **202.** Further, via manipulating the fixture **226,** the deposition source **242** is exposed to a given facet (such as, the first facet **202A)** to form a passivating layer (such as, the passivating layer **230** shown in FIG. 2B) onto the exposed facet of the cleaved semiconductor structure **202.** Further, via manipulating the fixture **226,** the heating source **222** is exposed to a given facet (such as, the first facet **202A)** to heat the exposed facet of the cleaved semiconductor structure **202** to aid with the above-described process. Herein, the heating source **222** may be employed either before or after, or during, the cleaning and/or oxidation process.

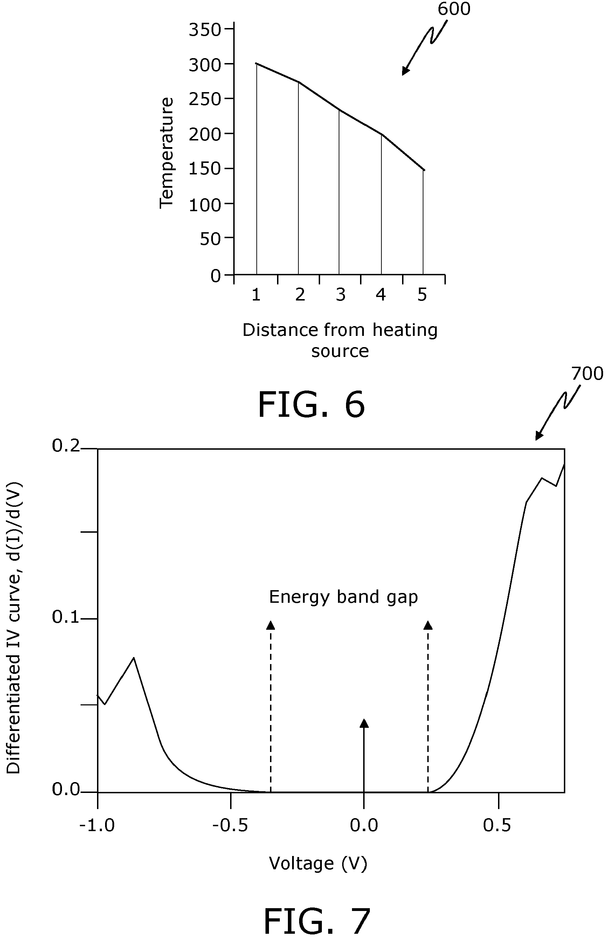

Referring to FIG. 6, illustrated is a graphical representation **600** of temperature variations in the cleaved semiconductor structure **202** as a measure of distance from the heating source, in accordance with an embodiment of the present disclosure. As shown, the x-axis and the y-axis depict the distance (in metres) from the heating source and the temperature (in degree Celsius), respectively. Herein, it is observed that temperature follows an inverse relationship with distance, as the temperature decreases with an increase in distance.

Referring to FIG. 7, illustrated is a graphical representation **700** of differentiated scanning tunnelling spectroscopy IV curve with respect to voltage in the edge-emitting laser device formed using the cleaved semiconductor structure **202,** in accordance with an embodiment of the present disclosure. As shown, the x-axis and the y-axis depict the differential IV (i.e., delta I/ delta V) and the voltage (in volts), respectively. Herein, an energy band gap is observed during operation. The edge-emitting laser device or the cleaved semiconductor structure **202** includes the ordered native oxide layer **236.** As discussed, the introduction of the ordered native oxide layer (such as, the ordered native oxide layer **236)** causes an increase in the energy band gap, in the semiconductor device. The higher energy gap gives the edge-emitting laser devices the ability to operate at higher temperatures, as the energy bandgaps typically shrink with increasing temperature, that presents problems during usage of conventional semiconductors. For example, wide-bandgap materials allow the edge-emitting laser devices to switch larger voltages.

## Claims

1. A method (100) of passivating a cleaved semiconductor structure for utilization as an edge-emitting laser device, the method (100) comprising:
- providing an enclosure having a first chamber and a second chamber, a transfer arm to receive and transfer a given structure from the first chamber to the second chamber, and a fixture to mount the given structure thereon in the second chamber, and with each of the first chamber and the second chamber adapted to provide vacuum condition inside thereof;
- loading the cleaved semiconductor structure defining a first facet, in the first chamber, onto the transfer arm therein;
- transferring the cleaved semiconductor structure from the first chamber to the second chamber using the transfer arm, to have the cleaved semiconductor structure mounted onto the fixture in the second chamber;
- exposing the first facet of the cleaved semiconductor structure in the second chamber to a cleaning beam from a cleaning source opposing the first facet by manipulating the fixture therein, to remove a possible native oxide layer formed on the first facet of the cleaved semiconductor structure;
- exposing the first facet of the cleaved semiconductor structure in the second chamber to heat energy from a heating source opposing the first facet by manipulating the fixture therein, to heat the first facet of the cleaved semiconductor structure; and
- exposing the first facet of the cleaved semiconductor structure in the second chamber to an oxidation agent from an oxidizing source opposing the first facet by manipulating the fixture therein, to form an ordered oxide layer on the first facet of the cleaved semiconductor structure.

2. A method (100) according to claim 1 further comprising, prior to exposing the first facet to the oxidation agent from the oxidizing source, exposing the first facet of the cleaved semiconductor structure in the second chamber to group III atoms from a deposition source opposing the first facet by manipulating the fixture therein, to deposit the group III atoms on the first facet of the cleaved semiconductor structure.

3. A method (100) according to any of claims 1 or 2 further comprising depositing a layer of at least one of Si, a-Si:H, SiO2, SiNx, over the ordered oxide layer formed on the first facet of the cleaved semiconductor structure.

4. A method (100) according to any of preceding claims, wherein the cleaning beam comprises at least one of: atomic beam of hydrogen, argon, xenon, or mixture thereof, ion beam comprising ionized noble gases and/or nitrogen.

5. A method (100) according to any of preceding claims, wherein the heat beam provided by the heating source is at least one of: laser irradiation, infrared radiation.

6. A method (100) according to any of preceding claims, wherein the oxidation agent comprises at least one of: molecular oxygen, oxygen plasma, ozone, NOx, CO.

7. A method (100) according to any of preceding claims, wherein a plurality of cleaved semiconductor structures are loaded in the first chamber, being stacked on top of each other at respective side facets thereof, with the first facet being orthogonal to the corresponding side facet in the respective cleaved semiconductor structure, and wherein the method (100) further comprises manipulating the fixture in the second chamber to expose the first facet of each of the cleaved semiconductor structure of the plurality of cleaved semiconductor structures to one or more of the cleaning beam from the cleaning source, the heat beam from the heating source and the oxidation agent from the oxidizing source.

8. A method (100) according to any of preceding claims, wherein the cleaved semiconductor structure further defines a second facet therein, and wherein the method (100) further comprises manipulating the fixture in the second chamber to expose the second facet of the cleaved semiconductor structure to one or more of the cleaning beam from the cleaning source, the heat beam from the heating source and the oxidation agent from the oxidizing source in the second chamber without removing the semiconductor structure from the enclosure.

9. A system (200) for passivating a cleaved semiconductor structure (202) for utilization as an edge-emitting laser, the system (200) comprising:
- an enclosure (204) having a first chamber (206) and a second chamber (208);
- a pump (210) configured to generate vacuum condition inside each of the first chamber (206) and the second chamber (208);
- a cleaning source (214) mounted in the second chamber;
- an oxidizing source (218) mounted in the second chamber;
- a heating source (222) mounted in the second chamber;
- a transfer arm (224) configured to receive and transfer the cleaved semiconductor structure (202), defining a first facet (202A), from the first chamber to the second chamber; and
- a fixture (226) adapted to mount the given structure thereon in the second chamber, wherein the fixture (226) is configured to be manipulated to:
- expose the first facet (202A) of the cleaved semiconductor structure in the second chamber to a cleaning beam from the cleaning source (214), by disposing the first facet opposing the cleaning source,
- expose the first facet of the cleaved semiconductor structure in the second chamber to heat energy from the heating source (222), by disposing the first facet opposing the heating source, and
- expose the first facet of the cleaved semiconductor structure in the second chamber to an oxidation agent from the oxidizing source (218), by disposing the first facet opposing the oxidizing source.

10. A system (200) according to claim 9, wherein the heating source (222) comprises at least one of: a laser, an infrared lamp.

## Patentansprüche

1. Verfahren (100) zum Passivieren einer gespaltenen Halbleiterstruktur für eine Verwendung als eine kantenemittierende Laservorrichtung, das Verfahren (100) umfassend:
- Bereitstellen eines Gehäuses, das eine erste Kammer und eine zweite Kammer aufweist, eines Übertragungsarms, um eine gegebene Struktur von der ersten Kammer in die zweite Kammer aufzunehmen und zu übertragen, und einer Befestigung, um die gegebene Struktur darauf in der zweiten Kammer zu montieren, und wobei sowohl die erste Kammer als auch die zweite Kammer angepasst sind, um einen Vakuumzustand innerhalb davon bereitzustellen;
- Laden der gespaltenen Halbleiterstruktur, die eine erste Facette definiert, in der ersten Kammer auf den Übertragungsarm darin;
- Übertragen der gespaltenen Halbleiterstruktur von der ersten Kammer in die zweite Kammer unter Verwendung des Übertragungsarms, um die gespaltene Halbleiterstruktur auf der Befestigung in der zweiten Kammer zu montieren;
- Aussetzen der ersten Facette der gespaltenen Halbleiterstruktur in der zweiten Kammer einem Reinigungsstrahl aus einer Reinigungsquelle, die der ersten Facette gegenüberliegt, durch Manipulieren der Befestigung darin, um eine mögliche natürliche Oxidschicht zu entfernen, die auf der ersten Facette der gespaltenen Halbleiterstruktur ausgebildet ist;
- Aussetzen der ersten Facette der gespaltenen Halbleiterstruktur in der zweiten Kammer einer Wärmeenergie aus einer Wärmequelle, die der ersten Facette gegenüberliegt, durch Manipulieren der Befestigung darin, um die erste Facette der gespaltenen Halbleiterstruktur zu erwärmen; und
- Aussetzen der ersten Facette der gespaltenen Halbleiterstruktur in der zweiten Kammer einem Oxidationsmittel aus einer oxidierenden Quelle, die der ersten Facette gegenüberliegt, durch Manipulieren der Befestigung darin, um eine geordnete Oxidschicht auf der ersten Facette der gespaltenen Halbleiterstruktur auszubilden.

2. Verfahren (100) nach Anspruch 1, ferner umfassend, vor dem Aussetzen der ersten Facette dem Oxidationsmittel aus der oxidierenden Quelle, das Aussetzen der ersten Facette der gespaltenen Halbleiterstruktur in der zweiten Kammer der Gruppe-III-Atome aus einer Abscheidungsquelle, die der ersten Facette gegenüberliegt, durch Manipulieren der Befestigung darin, um die Gruppe-III-Atome auf der ersten Facette der gespaltenen Halbleiterstruktur abzuscheiden.

3. Verfahren (100) nach einem der Ansprüche 1 oder 2, ferner umfassend das Abscheiden einer Schicht aus mindestens einem von Si, a-Si:H, SiO2, SiNx über der geordneten Oxidschicht, die auf der ersten Facette der gespaltenen Halbleiterstruktur ausgebildet ist.

4. Verfahren (100) nach einem der vorstehenden Ansprüche, wobei der Reinigungsstrahl mindestens eines umfasst von: einem Atomstrahl aus Wasserstoff, Argon, Xenon oder einer Mischung davon, einem Ionenstrahl, umfassend ionisierte Edelgase und/oder Stickstoff.

5. Verfahren (100) nach einem der vorstehenden Ansprüche, wobei der Wärmestrahl, der durch die Wärmequelle bereitgestellt wird, mindestens eines ist von: einer Laserbestrahlung, Infrarotbestrahlung.

6. Verfahren (100) nach einem der vorstehenden Ansprüche, wobei das Oxidationsmittel mindestens eines umfasst von: molekularem Sauerstoff, Sauerstoffplasma, Ozon, NOx, CO.

7. Verfahren (100) nach einem der vorstehenden Ansprüche, wobei eine Vielzahl von gespaltenen Halbleiterstrukturen in die erste Kammer geladen, an jeweiligen Seitenfacetten davon übereinander gestapelt werden, wobei die erste Facette orthogonal zu der entsprechenden Seitenfacette in der jeweiligen gespaltenen Halbleiterstruktur ist, und wobei das Verfahren (100) ferner das Manipulieren der Befestigung in der zweiten Kammer umfasst, um die erste Facette von jeder der gespaltenen Halbleiterstrukturen der Vielzahl von gespaltenen Halbleiterstrukturen einem oder mehreren des Reinigungsstrahls von der Reinigungsquelle, dem Wärmestrahl von der Wärmequelle und dem Oxidationsmittel von der oxidierenden Quelle auszusetzen.

8. Verfahren (100) nach einem der vorstehenden Ansprüche, wobei die gespaltene Halbleiterstruktur ferner eine zweite Facette darin definiert, und wobei das Verfahren (100) ferner das Manipulieren der Befestigung in der zweiten Kammer umfasst, um die zweite Facette der gespaltenen Halbleiterstruktur einem oder mehreren des Reinigungsstrahls von der Reinigungsquelle, dem Wärmestrahl von der Wärmequelle und dem Oxidationsmittel von der oxidierenden Quelle in der zweiten Kammer, ohne die Halbleiterstruktur aus dem Gehäuse zu entfernen, auszusetzen.

9. System (200) zum Passivieren einer gespaltenen Halbleiterstruktur (202) für die Verwendung als ein kantenemittierender Laser, das System (200) umfassend:
- ein Gehäuse (204), das eine erste Kammer (206) und eine zweite Kammer (208) aufweist;
- eine Pumpe (210), die konfiguriert ist, um innerhalb der ersten Kammer (206) und der zweiten Kammer (208) jeweils einen Vakuumzustand zu erzeugen;
- eine Reinigungsquelle (214), die in der zweiten Kammer montiert ist;
- eine oxidierende Quelle (218), die in der zweiten Kammer montiert ist;
- eine Wärmequelle (222), die in der zweiten Kammer montiert ist;
- einen Übertragungsarm (224), der konfiguriert ist, um die gespaltene Halbleiterstruktur (202), die eine erste Facette (202A) definiert, von der ersten Kammer in die zweite Kammer aufzunehmen und zu übertragen; und
- eine Befestigung (226), die angepasst ist, um die gegebene Struktur darauf in der zweiten Kammer zu montieren, wobei die Befestigung (226) konfiguriert ist, um manipuliert zu werden zum:
- Aussetzen der ersten Facette (202A) der gespaltenen Halbleiterstruktur in der zweiten Kammer einem Reinigungsstrahl aus der Reinigungsquelle (214), durch Anordnen der ersten Facette, die der Reinigungsquelle gegenüberliegt,
- Aussetzen der ersten Facette der gespaltenen Halbleiterstruktur in der zweiten Kammer der Wärmeenergie von der Wärmequelle (222), durch Anordnen der ersten Facette, die der Wärmequelle gegenüberliegt, und
- Aussetzen der ersten Facette der gespaltenen Halbleiterstruktur in der zweiten Kammer einem Oxidationsmittel aus der oxidierenden Quelle (218), durch Anordnen der ersten Facette, die der oxidierenden Quelle gegenüberliegt.

10. System (200) nach Anspruch 9, wobei die Wärmequelle (222) mindestens eines umfasst von: einem Laser, einer Infrarotlampe.

## Revendications

1. Procédé (100) permettant de passiver une structure semi-conductrice clivée pour une utilisation comme dispositif laser à émission latérale, le procédé (100) comprenant :
- la fourniture d'une enceinte possédant une première chambre et une seconde chambre, un bras de transfert pour recevoir et transférer une structure donnée de la première chambre à la seconde chambre, et un support pour monter la structure donnée sur celui-ci dans la seconde chambre, et avec chacune de la première chambre et de la seconde chambre adaptée pour fournir un état de vide à l'intérieur de celle-ci ;
- le chargement de la structure semi-conductrice clivée définissant une première facette, dans la première chambre, sur le bras de transfert à l'intérieur de celle-ci ;
- le transfert de la structure semi-conductrice clivée de la première chambre à la seconde chambre à l'aide du bras de transfert, pour que la structure semi-conductrice clivée soit montée sur le support dans la seconde chambre ;
- l'exposition de la première facette de la structure semi-conductrice clivée dans la seconde chambre à un faisceau de nettoyage provenant d'une source de nettoyage opposée à la première facette en manipulant le support à l'intérieur de celle-ci, pour éliminer une éventuelle couche d'oxyde natif formée sur la première facette de la structure semi-conductrice clivée ;
- l'exposition de la première facette de la structure semi-conductrice clivée dans la seconde chambre à de l'énergie thermique provenant d'une source de chauffage opposée à la première facette en manipulant le support à l'intérieur de celle-ci, pour chauffer la première facette de la structure semi-conductrice clivée ; et
- l'exposition de la première facette de la structure semi-conductrice clivée dans la seconde chambre à un agent d'oxydation provenant d'une source oxydante opposée à la première facette en manipulant le support à l'intérieur de celle-ci, pour former une couche d'oxyde ordonnée sur la première facette de la structure semi-conductrice clivée.

2. Procédé (100) selon la revendication 1 comprenant en outre, avant d'exposer la première facette à l'agent d'oxydation provenant de la source oxydante, l'exposition de la première facette de la structure semi-conductrice clivée dans la seconde chambre à des atomes du groupe III provenant d'une source de dépôt opposée à la première facette en manipulant le support à l'intérieur de celle-ci, pour déposer les atomes du groupe III sur la première facette de la structure semi-conductrice clivée.

3. Procédé (100) selon l'une quelconque des revendications 1 ou 2, comprenant en outre le dépôt d'une couche d'au moins l'un parmi Si, a-Si:H, SiO2, SiNx, sur la couche d'oxyde ordonné formée sur la première facette de la structure semi-conductrice clivée.

4. Procédé (100) selon l'une quelconque des revendications précédentes, dans lequel le faisceau de nettoyage comprend au moins l'un parmi : un faisceau atomique d'hydrogène, d'argon, de xénon, ou un mélange de ceux-ci, un faisceau d'ions comprenant des gaz rares ionisés et/ou de l'azote.

5. Procédé (100) selon l'une quelconque des revendications précédentes, dans lequel le faisceau de chaleur fourni par la source de chauffage est au moins l'un parmi : irradiation laser, rayonnement infrarouge.

6. Procédé (100) selon l'une quelconque des revendications précédentes, dans lequel l'agent d'oxydation comprend au moins l'un parmi : oxygène moléculaire, plasma d'oxygène, ozone, NOx, CO.

7. Procédé (100) selon l'une quelconque des revendications précédentes, dans lequel une pluralité de structures semi-conductrices clivées sont chargées dans la première chambre, empilées les unes sur les autres au niveau de leurs facettes latérales respectives, la première facette étant orthogonale à la facette latérale correspondante dans la structure semi-conductrice clivée respective, et dans lequel le procédé (100) comprend en outre la manipulation du support dans la seconde chambre pour exposer la première facette de chacune des structures semi-conductrices clivées de la pluralité de structures semi-conductrices clivées à l'un ou plusieurs parmi le faisceau de nettoyage provenant de la source de nettoyage, le faisceau de chaleur provenant de la source de chauffage et l'agent d'oxydation provenant de la source oxydante.

8. Procédé (100) selon l'une quelconque des revendications précédentes, dans lequel la structure semi-conductrice clivée définit en outre une seconde facette dans celle-ci, et dans lequel le procédé (100) comprend en outre la manipulation du support dans la seconde chambre pour exposer la seconde facette de la structure semi-conductrice clivée à l'un ou plusieurs parmi le faisceau de nettoyage provenant de la source de nettoyage, le faisceau de chaleur provenant de la source de chauffage et l'agent d'oxydation provenant de la source oxydante dans la seconde chambre sans retirer la structure semi-conductrice de l'enceinte.

9. Système (200) permettant de passiver une structure semi-conductrice clivée (202) pour une utilisation comme laser à émission latérale, le système (200) comprenant :
- une enceinte (204) possédant une première chambre (206) et une seconde chambre (208) ;
- une pompe (210) configurée pour générer un état de vide à l'intérieur de chacune de la première chambre (206) et de la seconde chambre (208) ;
- une source de nettoyage (214) montée dans la seconde chambre ;
- une source oxydante (218) montée dans la seconde chambre ;
- une source de chauffage (222) montée dans la seconde chambre ;
- un bras de transfert (224) conçu pour recevoir et transférer la structure semi-conductrice clivée (202), définissant une première facette (202A), de la première chambre à la seconde chambre ; et
- un support (226) adapté pour monter la structure donnée sur celui-ci dans la seconde chambre, dans lequel le support (226) est conçu pour être manipulé pour :
- exposer la première facette (202A) de la structure semi-conductrice clivée dans la seconde chambre à un faisceau de nettoyage provenant de la source de nettoyage (214), en disposant la première facette à l'opposé de la source de nettoyage,
- exposer la première facette de la structure semi-conductrice clivée dans la seconde chambre à de l'énergie thermique provenant de la source de chauffage (222), en disposant la première facette à l'opposé de la source de chauffage, et
- exposer la première facette de la structure semi-conductrice clivée dans la seconde chambre à un agent d'oxydation provenant de la source oxydante (218), en disposant la première facette à l'opposé de la source oxydante.

10. Système (200) selon la revendication 9, dans lequel la source de chauffage (222) comprend au moins l'un parmi : un laser, une lampe infrarouge.
